# EUROPEAN PATENT SPECIFICATION

(11) **EP 3 992 840 B1**
(45) Date of publication and mention of the grant of the patent: **12.11.2025**
(21) Application number: 19945470.3
(22) Date of filing: 20.12.2019
(51) Int. Cl.: G06F 3/041, G06V 40/13, H10K 59/131, H10K 59/126, H10K 71/00, G09G 3/3233

(54) **DISPLAY SUBSTRATE, MANUFACTURING METHOD THEREFOR, DISPLAY PANEL, AND DISPLAY DEVICE**
ANZEIGESUBSTRAT, HERSTELLUNGSVERFAHREN DAFÜR, ANZEIGETAFEL UND ANZEIGEVORRICHTUNG
SUBSTRAT D'AFFICHAGE, SON PROCÉDÉ DE FABRICATION, ÉCRAN D'AFFICHAGE ET DISPOSITIF D'AFFICHAGE

(43) Date of publication of application: 04.05.2022
(73) Proprietor: BOE Technology Group Co., Ltd., Beijing 100015 (CN); Chengdu BOE Optoelectronics Technology Co., Ltd., Chengdu, Sichuan 611731 (CN)
(72) Inventor: WEI, Yulong, Beijing 100176 (CN); ZHANG, Zhen, Beijing 100176 (CN)
(74) Representative: Isarpatent
(86) International application number: PCT/CN2019/126989
(87) International publication number: WO 2021/120172

(56) References cited:
- CN-A- 107 832 749
- CN-A- 107 832 749
- CN-A- 107 832 749
- CN-A- 109 686 773
- CN-A- 109 767 725
- CN-A- 109 992 155
- CN-A- 109 992 155
- CN-A- 110 046 611
- CN-A- 110 246 867
- US-A1- 2006 256 047
- US-A1- 2012 113 085
- US-A1- 2019 006 440
- US-A1- 2019 179 488
- US-A1- 2019 280 224
- US-A1- 2020 202 099
- ALAIN E. KALOYEROS ET AL: "Review?Silicon Nitride and Silicon Nitride-Rich Thin Film Technologies: Trends in Deposition Techniques and Related Applications", ECS JOURNAL OF SOLID STATE SCIENCE AND TECHNOLOGY, vol. 6, no. 10, 29 September 2017 (2017-09-29), US, pages P691 - P714, XP055695831, ISSN: 2162-8769, DOI: 10.1149/2.0011710jss

## Description

### TECHNICAL FIELD

The present disclosure relates to the field of display technology, in particular to a display substrate, a method for manufacturing display substrate, a display panel and a display device.

### BACKGROUND

With the advent of full-screen mobile phones, extensive research has been done into in-screen fingerprint identification. In the related art, a pinhole imaging principle is used for the in-screen fingerprint identification. At an active display area, pinholes are provided as imaging pinholes at regular intervals in pixels (a diameter of each imaging pinhole is usually greater than or equal to 5µm and smaller than or equal to 15µm), and a metal layer is deposited as a light-shielding layer at the active display area other than positions where the imaging pinholes are formed. However, in the related art, there is still room for improvement in an imaging effect of the fingerprint identification using the pinhole imaging principle.

CN 109 992 155 A relates to a display panel and a display device for fingerprint identification.

CN 107 832 749 A relates to an array substrate and a preparation method therefor, a fingerprint recognition method, and a display device.

US 2019/280224 A1 relates to a display device having ultraviolet light blocking properties.

### SUMMARY

The invention is set out in the appended set of claims.

### BRIEF DESCRIPTION OF THE DRAWINGS

Fig.1 is a schematic view showing a display substrate in related art;
Fig.2 is a schematic view showing a situation where a light-leakage pinhole occurs in the display substrate in related art;
Fig.3 is a schematic view showing a display substrate according to at least one embodiment of the present disclosure;
Fig.4 is a schematic view showing the display substrate according to at least one embodiment of the present disclosure;
Fig.5 is a circuit diagram of a pixel circuit in a TFT array layer according to at least one embodiment of the present disclosure;
Fig.6 is a partial schematic view showing a semiconductor material layer pattern of the TFT array layer;
Fig.7 is a schematic view showing conductive members on the basis of Fig.6;
Fig.8 is a partial schematic view showing a source/drain metal layer pattern of the TFT array layer;
Fig.9 is a partial schematic view showing a first gate metal layer pattern of the TFT array layer;
Fig.10 is a partial schematic view showing a second gate metal layer pattern of the TFT array layer;
Fig.11 is a top view of the semiconductor material layer pattern in Fig.7, the source/drain metal layer pattern in Fig.8, the first gate metal layer pattern in Fig.9 and the second gate metal layer pattern in Fig.10 when they are laminated one on another;
Fig.12 is a schematic view showing a position of a first sub-region A1;
Fig.13 is a schematic view showing a position of a second sub-region A2;
Fig.14 is a schematic view showing a position of a third sub-region A3;
Fig.15 is a schematic view showing a position of a fourth sub-region A4;
Fig.16 is a schematic view showing a position of a fifth sub-region A5;
Fig.17 is a schematic view showing a position of a pinhole region A0;
Fig.18 is a schematic view showing the display substrate with line A-A' on the basis of Fig. 12; and
Fig.19 is a sectional view of the display substrate along line A-A'.

### DETAILED DESCRIPTION

The present disclosure will be described hereinafter in a clear and complete manner in conjunction with the drawings and embodiments. Obviously, the following embodiments merely relate to a part of, rather than all of, the embodiments of the present disclosure, and based on these embodiments, a person skilled in the art may, without any creative effort, obtain the other embodiments, which also fall within the scope of the present disclosure.

The present disclosure provides in at least one embodiment a display substrate, which includes a base substrate, and a light-shielding layer and a TFT array layer arranged sequentially in that order on the base substrate. A plurality of imaging pinholes is formed in the light-shielding layer. A first protection layer is arranged between the light-shielding layer and the TFT array layer. The base substrate is provided with a first region, an orthogonal projection of a metal film layer of the TFT array layer onto the base substrate is located outside the first region, and at least a part of an orthogonal projection of the imaging pinhole onto the base substrate is located within the first region. An orthogonal projection of the first protection layer onto the base substrate at least covers a part of the first region. The first region includes a pinhole region, and at least a part of the orthogonal projection of the imaging pinhole onto the base substrate is located within the pinhole region. The orthogonal projection of the first protection layer onto the base substrate at least covers the pinhole region. The display substrate further includes a buffer layer arranged between the first protection layer and the TFT array layer.

In at least one embodiment of the present disclosure, the base substrate may be a flexible substrate, e.g., a polyimide (PI) substrate. However, the base substrate shall not be limited thereto.

In at least one embodiment of the present disclosure, the light-shielding layer may be made of, but not limited to, a metal material.

According to the display substrate in the at least one embodiment of the present disclosure, at least a part of the orthogonal projection of the imaging pinhole in the light-shielding layer onto the base substrate may be arranged within the first region, so as to prevent each imaging pinhole from being shielded by the metal film layer of the TFT array layer, thereby to perform the fingerprint identification in a better manner. In addition, through the first protection layer between the light-shielding layer and the TFT array layer, it is able to effectively prevent plasmas from being accumulated on the light-shielding layer and prevent an electric arc from breaking down the light-shielding layer, thereby to improve a fingerprint identification effect.

In the related art, during the manufacture of the display substrate, a semiconductor layer and an inorganic layer needs to be continuously deposited after the deposition of the light-shielding layer. The semiconductor layer and the inorganic layer are deposited through a high-temperature high-frequency film-forming process, so the plasmas may be accumulated at a surface of the light-shielding layer and the generated electric arc may break down the light-shielding layer, so as to form a light-leakage pinhole in the light-shielding layer. As a result, a slight light leakage may occur and the fingerprint identification effect may be adversely affected. Based on this, according to the display substrate in the at least one embodiment of the present disclosure, at least a part of the orthogonal projection of the imaging pinhole in the light-shielding layer onto the base substrate may be located within the first region, and the first protection layer may be arranged between the light-shielding layer and the TFT array layer.

During the implementation, the orthogonal projection of the first protection layer onto the base substrate may at least overlap a part of the first region, so as to prevent a portion of the light-shielding layer corresponding to the first region from being broken down by the electric arc to generate the light-leakage pinhole, thereby to prevent a fingerprint imaging effect from being adversely affected by stray light penetrating through the light-leakage pinhole.

In at least one embodiment of the present disclosure, the first region may include a pinhole region, and at least a part of the orthogonal projection of the imaging pinhole onto the base substrate may be located within the pinhole region.

During the implementation, the orthogonal projection of the first protection layer onto the base substrate may at least covers the pinhole region.

In at least one embodiment of the present disclosure, the buffer layer may be made of, but not limited to, silicon nitride, silicon oxide or polycrystalline silicon.

During the implementation, the buffer layer may have, but not limited to, a thickness greater than or equal to 200nm and smaller than or equal to 600nm.

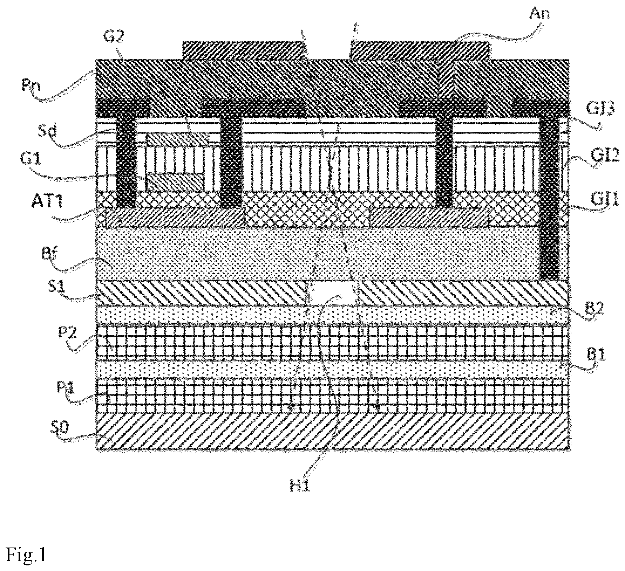

As shown in Fig.1, the display substrate in related art is not provided with any first protection layer. In Fig.1, the base substrate includes a first base substrate P1 and a second base substrate P2. A fingerprint identification layer S0 is arranged at a side of the first base substrate P1 distal to the second base substrate P2. A first barrier film layer B1 is arranged between the first base substrate P1 and the second base substrate P2, and a second barrier film layer B2 is arranged between the second base substrate P2 and a light-shielding layer S1. A first imaging pinhole H1 is formed in the shielding layer S1.

In the display substrate in Fig.1, a TFT array layer includes an active layer AT1, a first gate metal layer G1, a second gate metal layer G2, a first gate insulation layer GI1, a second gate insulation layer GI2, a third insulation layer GI3 and a source/drain metal layer Sd arranged sequentially in that order. The metal film layer of the TFT array layer includes the first gate metal layer G1, the second gate metal layer G2 and the source/drain metal layer Sd.

In the display substrate in Fig.1, a buffer layer Bf is arranged between the light-shielding layer S and the TFT array layer, a planarization layer Pn is arranged over the source/drain metal layer Sd, and an anode layer An is arranged on the planarization layer Pn.

In the display substrate of the related art in Fig.1, the anode layer An may be made of metal, e.g., silver. However, the material of the anode layer may not be limited thereto.

In the display substrate in Fig.1, the light-shielding layer S1 may be a metal layer, i.e., it may be made of a metal material, and a pattern of the metal layer may include a signal line. However, the material of the light-shielding layer S1 may not be limited thereto.

In the display substrate in Fig.1, the third insulation layer GI3 may be, but not limited to, an interlayer insulation layer.

Fig.1 merely shows the first imaging pinhole H1, and in actual use, a plurality of imaging pinholes may be formed in the light-shielding layer S1.

In Fig.1, a dotted line represents a light beam passing through the first imaging pinhole H1.

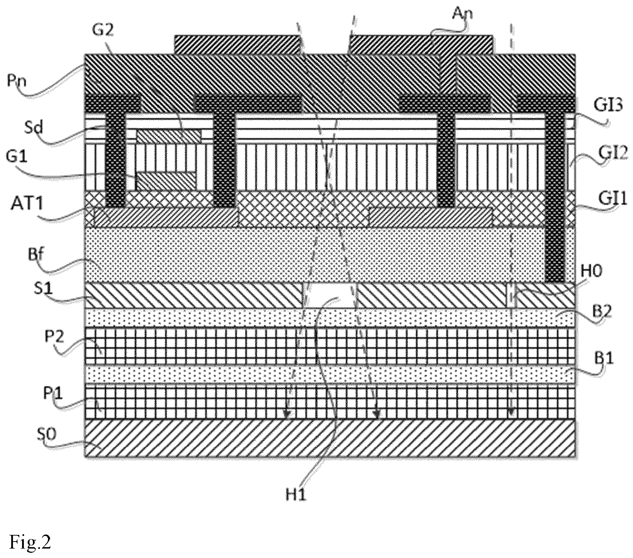

In the display substrate in Fig.1, the light is allowed to pass through the imaging pinhole H1 toward the fingerprint identification layer S0, so as to perform the fingerprint identification. However, after the deposition of the light-shielding layer S1, the semiconductor layer (e.g., the active layer) and the organic layer (e.g., the buffer layer) need to be deposited subsequently. The semiconductor layer and the inorganic layer are deposited through a high-temperature high-frequency film-forming process, so the plasmas may be accumulated at a surface of the light-shielding metal layer and the generated electric arc may break down the light-shielding layer as shown in Fig.2, so as to form a light-leakage pinhole H0 in the light-shielding layer. As a result, a slight light leakage may occur and the fingerprint identification effect may be adversely affected when the leaked light is detected by a fingerprint identification sensor in the fingerprint identification layer S0.

Based on the above, in the embodiments of the present disclosure, the first protection layer may be deposited after the deposition of the light-shielding layer and prior to the multi-deposition (i.e., the simultaneous deposition of the inorganic layer and the semiconductor layer), so as to effectively prevent the electric arc from breaking down the light-shielding layer.

In Fig.2, light beams represented by dotted lines include a light beam passing through the first imaging pinhole H1 and a light beam passing through the light-leakage pinhole H1. Preferably, a film-forming temperature of the first protection layer may be smaller than a threshold temperature, and the threshold temperature may be, but not limited to, greater than or equal to 230°C and smaller than or equal to 380°C.

In actual use, the threshold temperature may be adjusted according to the practical need.

In a preferred embodiment of the present disclosure, the first protection layer may be a low-temperature protection layer. The first protection layer may be formed through a low-temperature process after the deposition of the light-shielding layer, and then a film may be formed on the first protection layer at a high temperature and high power. Through the first protection layer, it is able to prevent the plasmas from being accumulated on the light-shielding layer, thereby to prevent the occurrence of arc breakdown. A specific film-forming condition may depend on the imaging definition and the process requirements.

In at least one embodiment of the present disclosure, the first protection layer may be made of an inorganic material or an organic material. For example, the first protection layer may be made of, but not limited to, silicon oxide or silicon nitride.

During the implementation, the first protection layer may have, but not limited to, a thickness greater than or equal to 100nm and smaller than or equal to 400nm.

In at least one embodiment of the present disclosure, the first protection layer may be a transparent film layer. Alternatively, the first protection layer may be nontransparent, and at this time a portion of the first protection layer at a position corresponding to the imaging pinhole needs to be removed through a mask, so as to prevent the light from being blocked during the pinhole imaging.

To be specific, the first protection layer may be made of, but not limited to, silicon oxide or silicon nitride.

During the implementation, the thickness of the first protection layer may be, but not limited to, greater than or equal to 100nm and smaller than or equal to 400nm.

To be specific, the display substrate may further include a fingerprint identification layer arranged at a side of the base substrate distal to the light-shielding layer and including a fingerprint identification sensor. The light-shielding layer may be arranged at a light-entering side of the fingerprint identification sensor, and the imaging pinhole may be arranged in such a manner as to allow light to pass therethrough toward the fingerprint identification sensor so as to perform the fingerprint identification.

During the implementation, the fingerprint identification layer may include, but not limited to, a plurality of fingerprint identification sensors arranged in an array form.

In at least one embodiment of the present disclosure, the light-shielding layer may be made of a nontransparent material, e.g., metal. However, the material of the light-shielding layer may not be limited thereto.

To be specific, the display substrate in the at least one embodiment of the present disclosure may further include a planarization layer and an anode layer arranged sequentially in that order at a side of the TFT array layer distal to the buffer layer, and an orthogonal projection of the imaging pinhole onto the base substrate may not overlap an orthogonal projection of the anode layer onto the base substrate.

In at least one embodiment of the present disclosure, the buffer layer may be made of, but not limited to, silicon nitride, silicon oxide or polycrystalline silicon.

During the implementation, the buffer layer may have, but not limited to, a thickness greater than or equal to 200nm and smaller than or equal to 600nm.

During the implementation, the anode layer may be made of, but not limited to, a material capable of reflecting light.

Preferably, the orthogonal projection of the imaging pinhole onto the base substrate may not overlap the orthogonal projection of the anode layer onto the base substrate, so as to prevent the imaging pinhole from being shielded by the anode layer that is capable of shielding the light, thereby to prevent the fingerprint imaging from being adversely affected.

To be specific, the display substrate in the at least one embodiment of the present disclosure may further include an organic light-emitting layer and a cathode layer arranged sequentially in that order at a side of the anode layer distal to the planarization layer.

During the implementation, the cathode layer may be made of, but not limited to, a transparent conductive material.

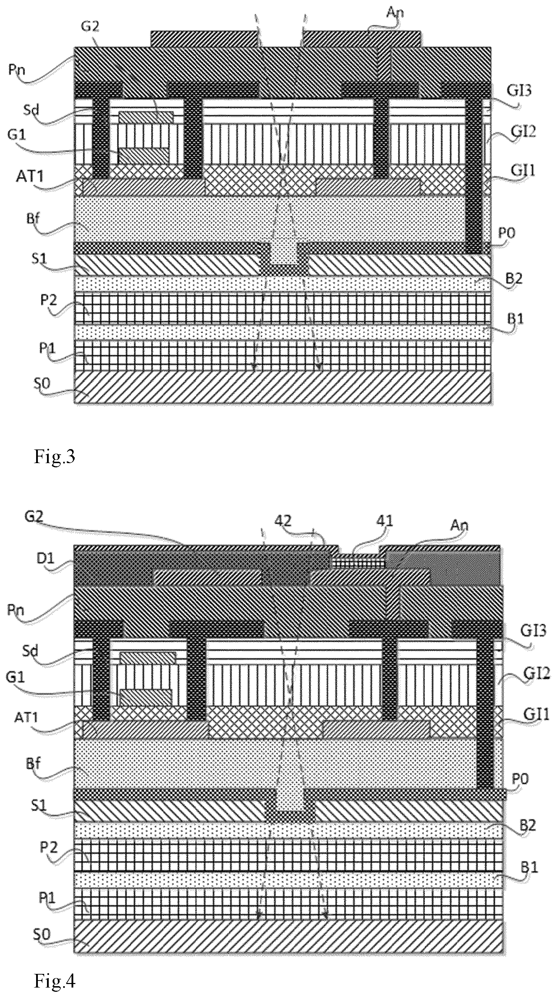

As shown in Fig.3, the display substrate in the at least one embodiment of the present disclosure may include a base substrate, and a light-shielding layer S1, a first protection layer P0 and a TFT array layer arranged sequentially in that order on the base substrate. A first imaging pinhole H1 may be formed in the light-shielding layer S1. The base substrate may include a first base substrate P1 and a second base substrate P2, a fingerprint identification layer S0 may be arranged at a side of the first base substrate P1 distal to the second base substrate P2, a first barrier film layer B1 may be arranged between the first base substrate P1 and the second base substrate P2, and a second barrier film layer B2 may be arranged between the second base substrate P2 and the light-shielding layer S1; the light-shielding layer S1 includes the first imaging pinhole H1.

In the display substrate in Fig.3 according to at least one embodiment of the present disclosure, the TFT array layer may include an active layer AT1, a first gate metal layer G1, a second gate metal layer G2, a first gate insulation layer GI1, a second gate insulation layer GI2, a third insulation layer GI3 and a source/drain metal layer Sd arranged sequentially in that order. The metal film layer of the TFT array layer may include the first gate metal layer G1, the second gate metal layer G2 and the source/drain metal layer Sd.

In the display substrate in Fig.3 according to at least one embodiment of the present disclosure, a buffer layer Bf may be arranged between the light-shielding layer S1 and the TFT array layer, a planarization layer Pn may be arranged over the source/drain metal layer Sd, and an anode layer An maybe arranged on the planarization layer Pn.

In at least one embodiment of the present disclosure, the third insulation layer GI3 may be, but not limited to, an interlayer insulation layer.

In the display substrate in Fig.3 according to at least one embodiment of the present disclosure, the anode layer An may be made of silver, or consist of an Indium Tin Oxide (ITO) layer, a silver layer and an ITO layer laminated one on another. However, a structure of the anode layer may not be limited thereto. In addition, Fig.3 merely shows the first imaging pinhole H1, and in actual use, a plurality of imaging pinholes may be formed in the light-shielding layer S1.

During the implementation, the plurality of imaging pinholes may correspond to pixel regions respectively, or one imaging pinhole may be arranged in a plurality of pixel regions, as long as the imaging accuracy is satisfied.

In the display substrate in Fig.3 according to at least one embodiment of the present disclosure, an orthogonal projection of the first imaging pinhole H1 onto the second base substrate P2 may not overlap an orthogonal projection of the metal film layer of the TFT array layer onto the second base substrate P2, and may not overlap an orthogonal projection of the anode layer An onto the second base substrate p2, so as to prevent the first imaging pinhole H1 from being shielded by the metal film layer and the anode layer An.

In addition, during the manufacture of the display substrate in Fig.3 according to at least one embodiment of the present disclosure, the first protection layer P0 may be formed through a low temperature process after the deposition of the light-shielding layer S1, and then a film may be formed on the first protection layer P0 at a high temperature and high power. Through the first protection layer P0, it is able to effectively prevent the plasmas from being accumulated on the light-shielding layer S1 and prevent the occurrence of a light-leakage pinhole when an electric arc breaks down the light-shielding layer S1, thereby to improve the fingerprint identification definition.

In at least one embodiment of the present disclosure, the first protection layer P0 may be formed through a low temperature process, and then the film may be formed on the first protection layer P0 at a high temperature and high power. The two film layers are formed at different film-forming temperatures and/or different film-forming powers, so there may exist an obvious interface between the two film layers.

During the manufacture of the display substrate in Fig.3 according to at least one embodiment of the present disclosure, the film-forming temperature of the first protection layer P0 may be, but not limited to, smaller than 230°C.

In Fig.3, a dotted line represents light beam passing through the first imaging pinhole H1.

In the display substrate in Fig.3 according to at least one embodiment of the present disclosure, the light-shielding layer S1 may be a metal layer, and a pattern of the metal layer may include a signal line. However, the light-shielding layer S1 may not be limited thereto.

During the implementation, in order to prevent the occurrence of static electricity, the light-shielding layer S1 shall not be in a floating state, i.e., a voltage needs to be applied to the light-shielding layer S1.

As shown in Fig.4, on the basis of the display substrate in Fig.3 according to at least one embodiment of the present disclosure, the display substrate may further include a pixel definition layer D1 arranged at a side of the anode layer An distal to the planarization layer Pn, and the pixel definition layer D1 is configured to define the pixel regions. The display substrate may further include an organic light-emitting layer 41 arranged at the pixel region, and a cathode layer 42 arranged on the organic light-emitting layer 41 .When the cathode layer 42 is touched by a finger, a light beam emitted by the organic light-emitting layer 41 toward the finger may be reflected by the finger downward to pass through the imaging pinhole in the light-shielding layer S1 toward the fingerprint identification layer S0, and the fingerprint identification layer S0 may detect the light beam to perform the fingerprint identification.

In the claimed invention, apart from the pinhole region, the first region includes another region. The orthogonal projection of the metal film layer of the TFT array layer onto the base substrate is not located within the other region. The orthogonal projection of the imaging pinhole onto the base substrate may not be located within the other regions, and instead, it may be located at a position close to the other regions. Hence, when the other regions are not protected by the first protection layer, the fingerprint imaging effect may be adversely affected too.

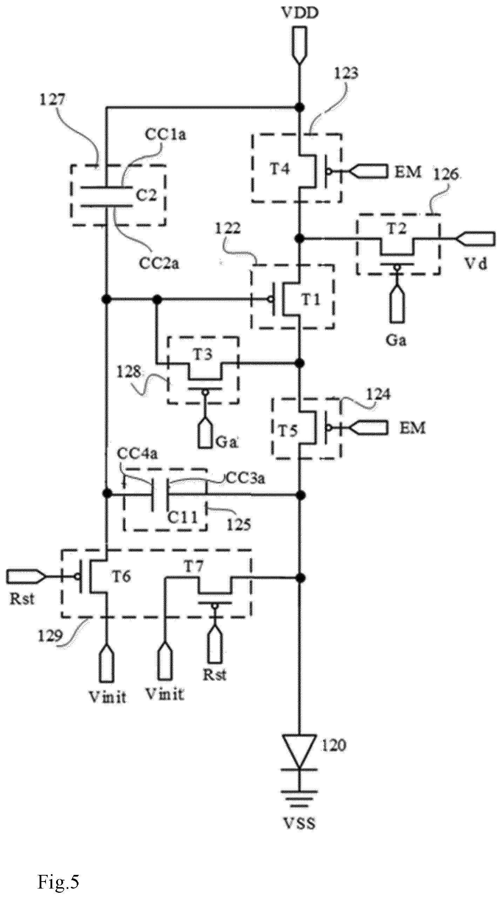

During the implementation, the TFT array layer may include a pixel circuit, and Fig.5 shows a circuit diagram of the pixel circuit according to at least one embodiment of the present disclosure.

As shown in Fig.5, the pixel circuit may include a light-emitting element 120, a driving circuitry 122, a first light-emission control circuitry 123 and a second light-emission control circuitry 124. The driving circuitry 122 may include a control end, a first end and a second end, and configured to supply a driving current to the light-emitting element 120 to drive the light-emitting element 120 to emit light. For example, the second light-emission control circuitry 123 may be connected to a first end of the driving circuitry 122 and a first power source line VDD, and configured to control the driving circuitry 122 to be electrically connected to or electrically disconnected from the first power source line VDD. The first light-emission control circuitry 124 may be electrically connected to a second end of the driving circuitry 122 and an electrode of the light-emitting element 120 to which a first light-emission voltage is to be applied, and configured to control the driving circuitry 122 to be electrically connected to or electrically disconnected from the light-emitting element 120.

As shown in Fig.5, the pixel circuit 121 may further include a data write-in circuitry 126, a first storage circuitry 127, a threshold compensation circuitry 128, a resetting circuitry 129 and a second storage circuitry 130. The data write-in circuitry 126 may be electrically connected to the first end of the driving circuitry 122, and configured to write a data voltage across a data line Vd into the first storage circuitry 127 under the control of a scanning signal. The first storage circuitry 127 may be electrically connected to a control end of the driving circuitry 122 and the first power source line VDD, and configured to store the data voltage. The threshold compensation circuitry 128 may be electrically connected to the control end and the second end of the driving circuitry 122, and configured to perform threshold compensation on the driving circuitry 122. The resetting circuitry 129 may be electrically connected to the control end of the driving circuitry 122 and the electrode of the light-emitting element 120 to which the first light-emission voltage is to be applied, and configured to reset the control end of the driving circuitry 122 and the electrode of the light-emitting element 120 to which the first light-emission voltage is to be applied under the control of a resetting control signal.

For example, as shown in Fig.5, the driving circuitry 122 may include a driving transistor T1, the control end of the driving circuitry 122 may include a gate electrode of the driving transistor T1, the first end of the driving circuitry 122 may include a first electrode of the driving transistor T1, and the second end of the driving circuitry 122 may include a second electrode of the driving transistor T1.

For example, as shown in Fig.5, the data write-in circuitry 126 may include a data write-in transistor T2, the first storage circuitry 127 may include a first storage capacitor C2, the threshold compensation circuitry 128 may include a threshold compensation transistor T3, the second light-emission control circuitry 123 may include a second light-emission control transistor T4, the first light-emission control circuitry 124 may include a first light-emission control transistor T5, and the resetting circuitry 129 may include a first resetting transistor T6 and a second resetting transistor T7.

For example, as shown in Fig.5, a first electrode of the data write-in transistor T2 may be electrically connected to the first electrode of the driving transistor T1, a second electrode thereof may be electrically connected to the data line Vd to receive the data voltage, and a gate electrode thereof may be electrically connected to a gate line Ga to receive the scanning signal. A first electrode plate CC1a of the first storage capacitor C2 may be electrically connected to the first power source line VDD, and a second electrode plate CC2a thereof may be electrically connected to the gate electrode of the driving transistor T1. A first electrode of the threshold compensation transistor T3 may be electrically connected to the second electrode of the driving transistor T1, a second electrode thereof may be electrically connected to the gate electrode of the driving transistor T1, and a gate electrode thereof may be electrically connected to the gate line Ga to receive the scanning signal. A first electrode of the first resetting transistor T6 may be electrically connected to a resetting power source line Vinit to receive a resetting signal, a second electrode thereof may be electrically connected to the gate electrode of the driving transistor T1, and a gate electrode thereof may be electrically connected to a resetting control signal line Rst to receive a resetting control signal. A first electrode of the second resetting transistor T7 may be electrically connected to the resetting power source line Vinit to receive the resetting signal, a second electrode thereof may be electrically connected to the electrode of the light-emitting element 120 to which the first light-emission voltage is to be applied, and a gate electrode thereof may be electrically connected to the resetting control signal line Rst to receive the resetting control signal. A first electrode of the second light-emission control transistor T4 may be electrically to the first power source line VDD, a second electrode thereof may be electrically connected to the first electrode of the driving transistor T1, and a gate electrode thereof may be electrically connected to a light-emission control signal line EM to receive a light-emission control signal. A first electrode of the first light-emission control transistor T5 may be electrically connected to the second electrode of the driving transistor T1, a second electrode thereof may be electrically connected to the electrode of the light-emitting element 120 to which the first light-emission voltage is to be applied, and a gate electrode thereof may be electrically connected to the light-emission control signal line EM to receive the light-emission control signal. An electrode of the light-emitting element 120 to which a second light-emission voltage is to be applied may be electrically connected to a second power source line VSS.

For example, as shown in Fig.5, the second storage circuitry 130 may include a second storage capacitor C11, a first electrode plate CC3a of which is electrically connected to the electrode of the light-emitting element 120 to which the first light-emission voltage is to be applied, and a second electrode plate CC4a of which is electrically connected to the gate electrode of the driving transistor T1.

For example, one of the first power source line VDD and the second power source line VSS may be a high voltage line, and the other may be a low voltage line. For example, as shown in Fig.5 according to at least one embodiment of the present disclosure, the first power source line VDD may be a voltage source capable of outputting a first voltage of a constant value, and the first voltage may be a positive voltage; the second power source line VSS may be a voltage source capable of outputting a second voltage of a constant value, and the second voltage may be a negative voltage. In some embodiments of the present disclosure, the second power source line VSS may be grounded.

For example, the resetting power source line Vinit may be a direct current reference voltage line capable of outputting a direct current reference voltage of a constant value. The resetting power source line Vinit may be a high voltage line or a low voltage line, as long as the resetting signal is capable of being applied to reset the gate electrode of the driving transistor T1 and the electrode of the light-emitting element 120 to which the first light-emission voltage is to be applied, which will not be particularly defined herein.

It should be appreciated that, the gate electrodes of T6 and T7 may be connected to different resetting control signal lines, the first electrodes of T6 and T7 may be connected to different resetting power source lines, the gate electrodes of T4 and T5 may be connected to different light-emission control signal lines, and the gate electrodes of T2 and T3 may be connected to different gate lines, which will not be particularly defined herein.

It should be further appreciated that, the driving circuitry 122, the data write-in circuitry 126, the storage circuitry 127, the threshold compensation circuitry 128 and the resetting circuitry 129 of the pixel circuit in Fig.5 are for illustrative purposes only, and specific structures of the circuitries such as the driving circuitry 122, the data write-in circuitry 126, the storage circuitry 127, the threshold compensation circuitry 128 and the resetting circuitry 129 may be set according to the practical need, which will not be particularly defined herein.

For example, depending on characteristics of the transistors, the transistors may include N-type transistors and P-type transistors. For clarification, in the embodiments of the present disclosure, the P-type transistors will be taken as an example. In other words, in the description of the present disclosure, the driving transistor T1, the data write-in transistor T2, the threshold compensation transistor T3, the second light-emission control transistor T4, the first light-emission control transistor T5, the first resetting transistor T6 and the second resetting transistor T7 may all be P-type transmissions. However, the transistors in the embodiments of the present disclosure may not be limited to the P-type transistors, and the N-type transistors may also be adopted according to the practical need, so as to achieve functions of one or more of the transistors.

It should be appreciated that, the transistors adopted in the embodiments of the present disclosure may be TFTs, Field Effect Transistors (FETs) or any other switching elements having a same characteristic. The TFT may include an oxide semiconductor TFT, an amorphous silicon TFT or a polycrystalline silicon TFT. A source electrode and a drain electrode of the transistor may be arranged symmetrically in structure, so they may be the same in the physical structure. In the embodiments of the present disclosure, in order to differentiate electrodes of the transistor, apart from a gate electrode as a control electrode, one of the two electrodes may be directly described as a first electrode, and the other may be described as a second electrode. Hence, in the embodiments of the present disclosure, the first electrode and the second electrode of each of all of or parts of the transistors may be replaced with each other according to the practical need.

During the implementation, the TFT array layer may include a semiconductor material layer, a first gate metal layer, a second gate metal layer and a source/drain metal layer.

In at least one embodiment of the present disclosure, the semiconductor material layer may be, but not limited to, an active layer.

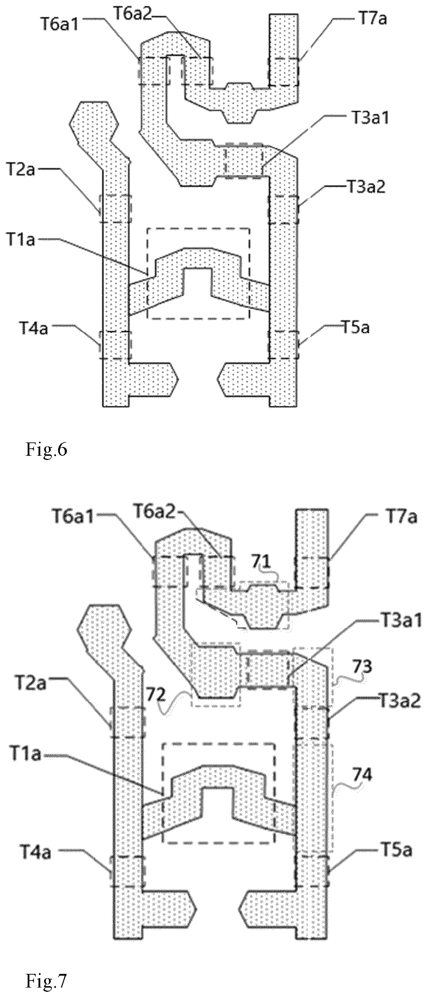

Fig.6 is a partial schematic view showing a semiconductor material layer pattern, and the semiconductor material layer pattern may be, but not limited to, an active layer pattern.

As shown in Fig.6, a semiconductor material layer pattern of the threshold compensation transistor T3 may include a first channel member T3a1 and a second channel member T3a2, a semiconductor material layer pattern of the first light-emission control transistor T5 may include a third channel member T5a, a semiconductor material layer pattern of the driving transistor T1 may include a fourth channel member T1a, a semiconductor material layer pattern of the data write-in transistor T2 may include a fifth channel member T2a, a semiconductor material layer pattern of the second light-emission control transistor T4 may include a sixth channel member T4a, a semiconductor material layer pattern of the first resetting transistor T6 may include a seventh channel member T6a1 and an eighth channel member T6a2, and a semiconductor material layer pattern of the second resetting transistor T7 may include a ninth channel member T7a.

In Fig.7, on the basis of the semiconductor material layer patterns in Fig.6, 71 represents a first conductive member of the semiconductor material layer pattern of the first resetting transistor T6, 72 represents a second conductive member of the semiconductor material layer pattern of the threshold compensation transistor T3. In Fig.7, 73 represents a third conductive member of the semiconductor material layer pattern of the threshold compensation transistor T3 which is arranged between the first channel member T3a1 and the second channel member T3a2, and 74 represents a fourth conductive member of the semiconductor material layer pattern of the first light-emission control transistor T5 which is arranged between the second channel member T3a2 and the third channel member T5a.

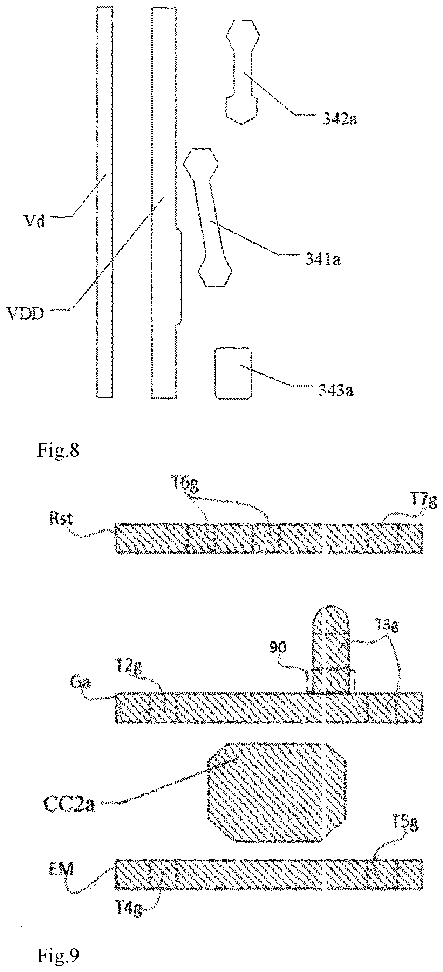

Fig.8 is a partial schematic view showing the source/drain metal layer pattern. In Fig.8, 342a represents the first electrode of the first resetting transistor T6, 341a represents the second electrode of the threshold compensation transistor T3, 343a represents the third electrode of the first light-emission control transistor T5, Vd represents the data line, and VDD represents the first power source line.

In at least one embodiment of the present disclosure, the first electrode 342a of T6 may be a source electrode of T6, the second electrode 341a of T3 may be a source electrode of T3, and the third electrode 343a of T5 may be a drain electrode of T5. However, the present disclosure shall not be limited thereto.

In Fig.9, T6g represents a gate electrode of T6, T7g represents a gate electrode of T7, T2g represents a gate electrode of T2, T4g represents a gate electrode of T4, T5g represents a gate electrode of T5, and T3g represents a gate electrode of T3. The gate electrode of T1 may be reused as CC2a and CC4a.

In Fig.9, Rst represents the resetting control signal line, Ga represents the gate line, and EM represents the light-emission control signal line.

In Fig.9, 90 represents a first gate metal pattern arranged between the gate line Ga and the gate electrode T3g of T3.

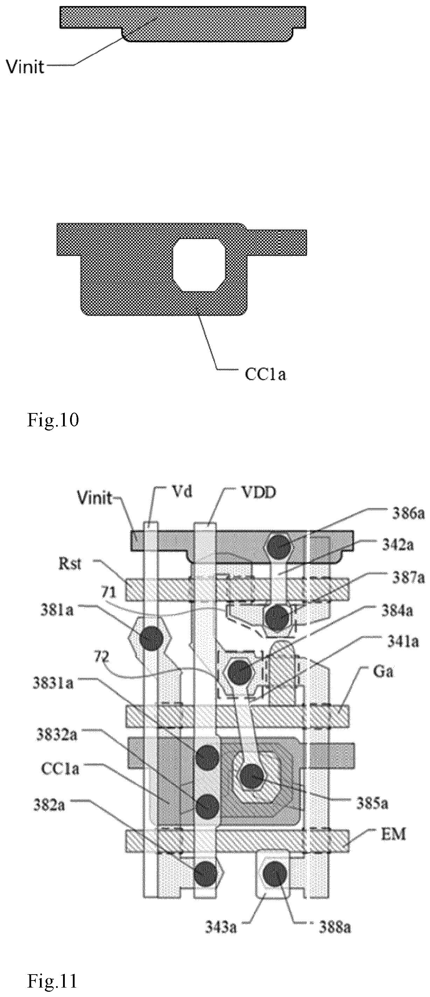

In Fig.10, Vinit represents the resetting power source line, and CC1a represents the first electrode plate of C2.

Fig.11 is a top view of the display substrate when the semiconductor material layer pattern in Fig.7, the source/drain metal layer pattern in Fig.8, the first gate metal layer pattern in Fig.9 and the second gate metal layer pattern in Fig.10 are laminated one on another.

In Fig.11, 383a represents a first via-hole, 382a represents a second via-hole, 383a represents a third via-hole, 384a represents a fourth via-hole, 385a represents a fifth via-hole, 386a represents a sixth via-hole, 387a represents a seventh via-hole, and 388a represents an eighth via-hole. The third electrode 343a of T5 may be electrically connected to the anode layer through the eighth via-hole 388a.

As shown in Fig.11, the first conductive member 71 may be electrically connected to the first electrode 342a of the first resetting transistor through the seventh via-hole 387a, the first electrode 342a may be electrically connected to the resetting power source line Vinit through the sixth via-hole 386a, the second conductive member 72 may be electrically connected to the second electrode 341a of the threshold compensation transistor through the fourth via-hole 384a, and the second electrode 341a may be electrically connected to the gate electrode of the driving transistor through the fifth via-hole 385a.

In at least one embodiment of the present disclosure, the first region may include a first sub-region. The TFT array layer may include a resetting power source line, a first resetting transistor, a threshold compensation transistor and a driving transistor. The first sub-region may not overlap an orthogonal projection of a first conductive member included in a semiconductor material layer pattern of the first resetting transistor onto the base substrate and an orthogonal projection of a second conductive member included in a semiconductor material layer pattern of the threshold compensation transistor onto the base substrate. The first conductive member may be electrically connected to a first electrode of the first resetting transistor, and the first electrode may be electrically connected to the resetting power source line. The second conductive member may be electrically connected to a second electrode of the threshold compensation transistor, and the second electrode may be electrically connected to a gate electrode of the driving transistor.

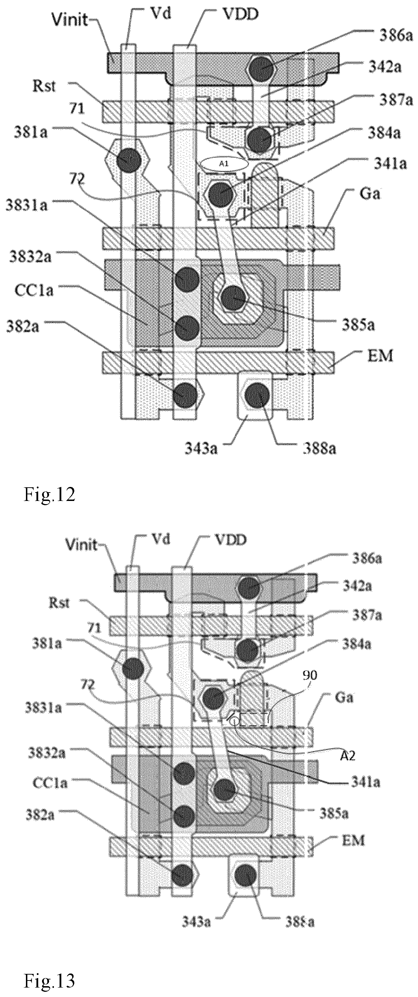

As shown in Fig.12, the first region may include a first sub-region A1. The first sub-region A1 may not overlap an orthogonal projection of the first conductive member 71 in the semiconductor material layer pattern of the first resetting transistor T6 onto the base substrate and an orthogonal projection of the second conductive member 72 in the semiconductor material layer pattern of the threshold compensation transistor T3 onto the base substrate. The first conductive member 71 may be electrically connected to the first electrode 342a of the first resetting transistor T6, and the first electrode 342a may be electrically connected to the resetting power source line Vinit. The second conductive member 72 may be electrically connected to the second electrode 341a of the threshold compensation transistor T3, and the second electrode 341a may be electrically connected to the gate electrode of the driving transistor T1.

In at least one embodiment of the present disclosure, the first region may include a second sub-region, and the TFT array layer may include a gate line, a threshold compensation transistor and a driving transistor. The second sub-region may not overlap an orthogonal projection of the gate line onto the base substrate, an orthogonal projection of a second electrode of the threshold compensation transistor onto the base substrate, an orthogonal projection of a second conductive member included in a semiconductor material layer pattern of the threshold compensation transistor onto the base substrate, and an orthogonal projection of a first gate metal pattern onto the base substrate. The second conductive member may be electrically connected to the second electrode of the threshold compensation transistor, and the second electrode may be electrically connected to a gate electrode of the driving transistor. The first gate metal pattern may be a gate metal pattern arranged between the gate line included in a first gate metal layer of the TFT array layer and the gate electrode of the threshold compensation transistor.

As shown in Fig.13, the first region may include a second sub-region A2. The second sub-region A2 may not overlap an orthogonal projection of the gate line Ga onto the base substrate, an orthogonal projection of the second electrode 341a of the threshold compensation transistor T3 onto the base substrate, an orthogonal projection of the second conductive member 72 in the semiconductor material layer pattern of the threshold compensation transistor T3 onto the base substrate, and an orthogonal projection of the first gate metal pattern 90 onto the base substrate. The second conductive member 72 may be electrically connected to the second electrode 341a of the threshold compensation transistor T3, and the second electrode 341a may be electrically connected to the gate electrode of the driving transistor T1. The first gate metal pattern 90 may be a gate metal pattern arranged between the gate line Ga in the first gate metal layer of the TFT array layer and the gate electrode of the threshold compensation transistor T3.

In at least one embodiment of the present disclosure, the first region may include a third sub-region, and the TFT array layer may include a gate line, a threshold compensation transistor and a driving transistor. The third sub-region does not overlap an orthogonal protection of the gate line onto the base substrate, an orthogonal projection of a third conductive member included in a semiconductor material layer pattern of the threshold compensation transistor onto the base substrate and an orthogonal projection of a first gate metal pattern onto the base substrate. The semiconductor material layer pattern of the threshold compensation transistor may include a first channel member and a second channel member, and the third conductive member may be arranged between the first channel member and the second channel member. The first gate metal pattern may be a gate metal pattern arranged between the gate line included in the first gate metal layer of the TFT array layer and a gate electrode of the threshold compensation transistor.

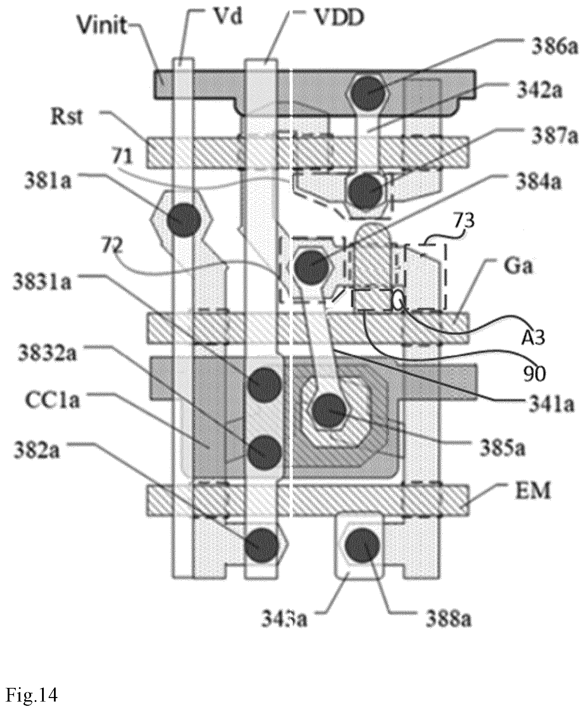

As shown in Fig.14, the first region may include a third sub-region A3. The third sub-region A3 may not overlap an orthogonal protection of the gate line Ga onto the base substrate, an orthogonal projection of the third conductive member 73 in the semiconductor material layer pattern of the threshold compensation transistor T3 onto the base substrate and an orthogonal projection of the first gate metal pattern 90 onto the base substrate. The semiconductor material layer pattern of the threshold compensation transistor T3 may include the first channel member T3a1 and the second channel member T3a2, and the third conductive member 73 may be arranged between the first channel member T3a1 and the second channel member T3a2. The first gate metal pattern 90 may be a gate metal pattern arranged between the gate line Ga in the first gate metal layer of the TFT array layer and the gate electrode of the threshold compensation transistor T3.

In at least one embodiment of the present disclosure, the first region may include a fourth sub-region, and the TFT array layer may include a gate line, a first capacitor, a threshold compensation transistor and a first light-emission control transistor. The fourth sub-region may not overlap an orthogonal projection of the gate line onto the base substrate, an orthogonal projection of a first electrode plate of the first capacitor onto the base substrate, an orthogonal projection of a second electrode of the threshold compensation transistor onto the base substrate, and an orthogonal projection of a fourth conductive member included in a semiconductor material layer pattern of the first light-emission control transistor onto the base substrate. A semiconductor material layer pattern of the threshold compensation transistor may include a first channel member and a second channel member, and the semiconductor material layer pattern of the first light-emission control transistor may include a third channel member. The fourth conductive member may be arranged between the second channel member and the third channel member.

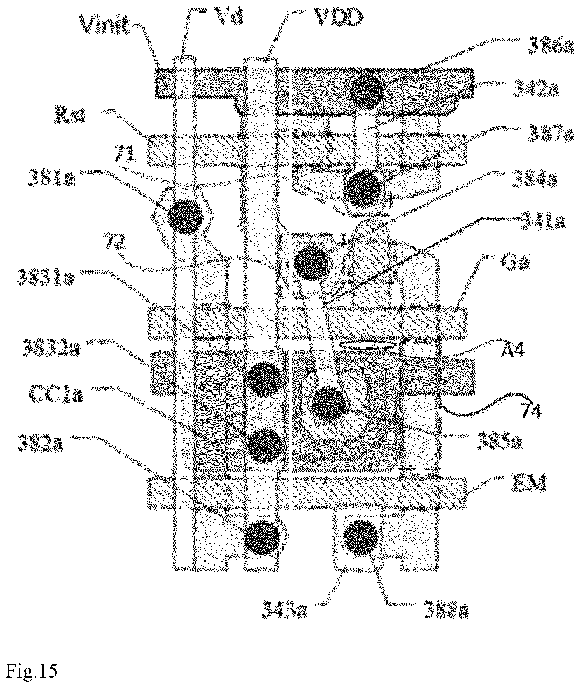

As shown in Fig.15, the first region may include a fourth sub-region A4. The fourth sub-region A4 may not overlap an orthogonal projection of the gate line Ga onto the base substrate, an orthogonal projection of the first electrode plate CC1a of the first capacitor C2 onto the base substrate, an orthogonal projection of the second electrode 341a of the threshold compensation transistor T3 onto the base substrate, and an orthogonal projection of the fourth conductive member 74 in the semiconductor material layer pattern of the first light-emission control transistor T5 onto the base substrate. The semiconductor material layer pattern of the threshold compensation transistor T3 may include the first channel member T3a1 and the second channel member T3a2, and the semiconductor material layer pattern of the first light-emission control transistor T5 may include the third channel member T5a. The fourth conductive member 74 may be arranged between the second channel member T3a2 and the third channel member T5a.

In the claimed invention, the first region includes a fifth sub-region, and the TFT array layer includes a first capacitor, a threshold compensation transistor, a first light-emission control transistor, a first power source line and a light-emission control signal line. The fifth sub-region may not overlap an orthogonal projection of a first electrode plate of the first capacitor onto the base substrate, an orthogonal projection of the light-emission control signal line onto the base substrate, an orthogonal projection of the first power source line onto the base substrate, and an orthogonal projection of a fourth conductive member included in a semiconductor material layer pattern of the first light-emission control transistor onto the base substrate. A semiconductor material layer pattern of the threshold compensation transistor may include a first channel member and a second channel member, and the semiconductor material layer pattern of the first light-emission control transistor may include a third channel member. The fourth conductive member may be arranged between the second channel member and the third channel member.

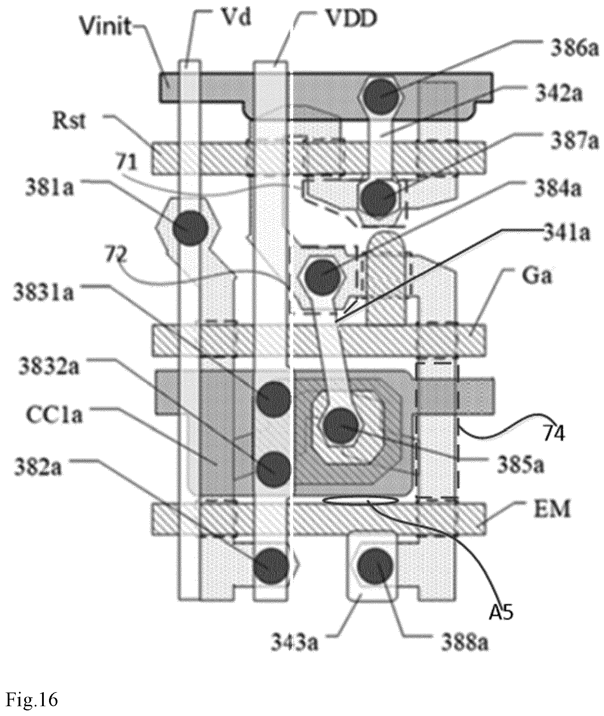

In the claimed invention, as shown in Fig.16, the first region includes a fifth sub-region A5. The fifth sub-region A5 does not overlap an orthogonal projection of the first electrode plate CC1a of the first capacitor C2 onto the base substrate, an orthogonal projection of the light-emission control signal line EM onto the base substrate, an orthogonal projection of the first power source line VDD onto the base substrate, and an orthogonal projection of the fourth conductive member 74 in the semiconductor material layer pattern of the first light-emission control transistor T5 onto the base substrate. The semiconductor material layer pattern of the threshold compensation transistor T3 may include the first channel member T3a1 and the second channel member T3a2, and the semiconductor material layer pattern of the first light-emission control transistor T5 may include the third channel member T5a. The fourth conductive member 74 may be arranged between the second channel member T3a2 and the third channel member T5a.

During the implementation, in at least one embodiment of the present disclosure, the display substrate may further include an anode layer arranged at a side of the TFT array layer distal to the first protection layer, the TFT array layer may include a first power source line and a first light-emission control transistor, the pinhole region may not overlap an orthogonal projection of the first power source line onto the base substrate and an orthogonal projection of a third electrode of the first light-emission control transistor onto the base substrate, and the third electrode may be electrically connected to the anode layer.

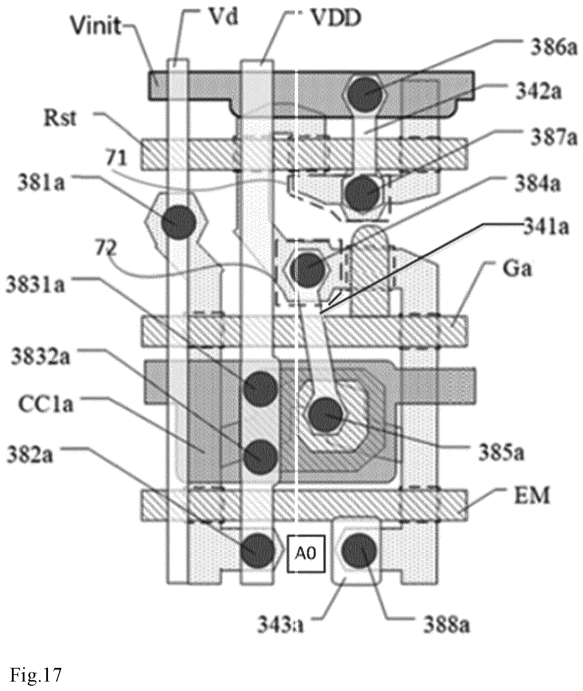

As shown in Fig.17, the pinhole region A0 may not overlap the orthogonal projection of the first power source line VDD onto the base substrate and the orthogonal projection of the third electrode 343a of the first light-emission control transistor T5 onto the base substrate.

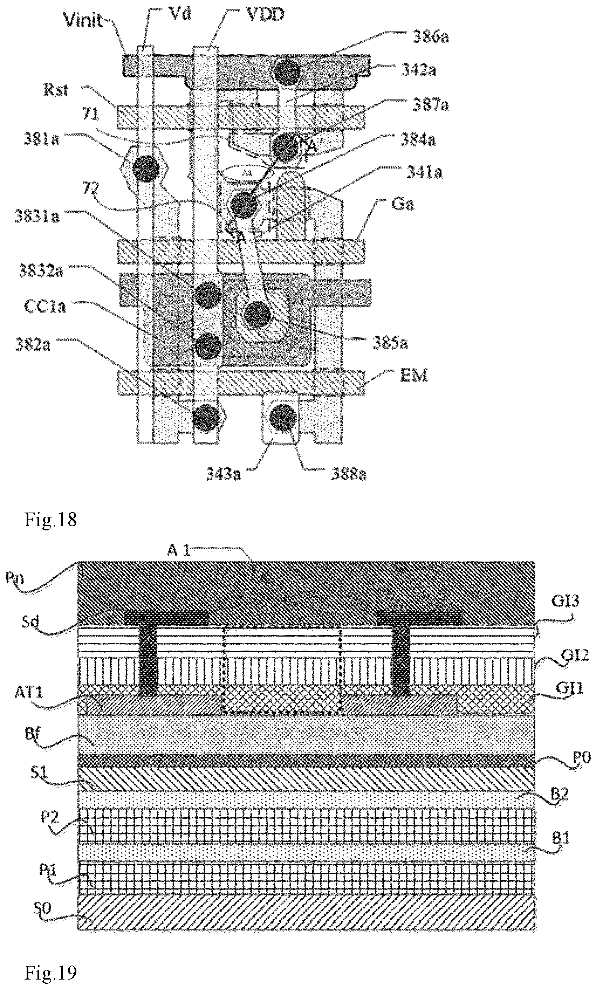

In Fig.18, a line A-A' is added on the basis of Fig.12, and Fig.19 is a sectional view along the line A-A'.

As shown in Fig.19, at least the first gate insulation layer GI1, the second gate insulation layer GI2 and the third insulation layer GI3 may be arranged at the first sub-region A1.

In Fig.19, S0 represents the fingerprint identification layer, P1 represents the first base substrate, B1 represents, P2 represents the second base substrate, B2 represents, S1 represents the light-shielding layer, P0 represents the first protection layer, Bf represents the buffer layer, AT1 represents the active layer, Sd represents the source/drain metal layer, and Pn represents the planarization layer.

In at least one embodiment of the present disclosure, at least the first gate insulation layer GI1, the second gate insulation layer GI2 and the third insulation layer GI3 may be arranged at each of the sub-regions of the first region. However, the present disclosure shall not be limited thereto.

In addition, Fig.19 also shows a sectional view along a line connecting a via-hole on the left of the pinhole region AO, the pinhole region A0 and a via-hole on the right of the pinhole region A0 in Fig.17. However, the present disclosure shall not be limited thereto.

During the implementation, the metal film layer of the TFT array layer may include a first metal layer, a second metal layer and a third metal layer. The gate line, the resetting control signal line, the light-emission control signal line, the second electrode plate of the first storage capacitor and the gate electrode of each transistor in the pixel circuit may be arranged at the first metal layer, the resetting power source line and the first electrode plate of the first storage capacitor may be arranged at the second metal layer, and the first power source line, the data line and the first electrode and the second electrode of the transistor may be arranged at the third metal layer.

In at least one embodiment of the present disclosure, the first metal layer may be the first gate metal layer, the second metal layer may be the second gate metal layer, and the third metal layer may be the source/drain metal layer. However, the present disclosure shall not be limited thereto.

The present disclosure further provides in at least one embodiment a method for manufacturing a display substrate, which includes: forming a light-shielding layer on a base substrate, the base substrate being provided with a first region, a plurality of imaging pinholes being formed in the light-shielding layer, at least a part of an orthogonal projection of the imaging pinhole onto the base substrate being located within the first region; forming a first protection layer at a side of the light-shielding layer distal to the base substrate; and forming a TFT array layer on the first protection layer in such a manner that an orthogonal projection of a metal film layer of the TFT array layer onto the base substrate is located outside the first region. An orthogonal projection of the first protection layer onto the base substrate at least may cover a part of the first region. The first region may include a pinhole region, at least a part of the orthogonal projection of the imaging pinhole onto the base substrate may be located within the pinhole region, and the orthogonal projection of the first protection layer onto the base substrate may at least cover the pinhole region.

According to the method for manufacturing the display substrate in the at least one embodiment of the present disclosure, at least a part of the orthogonal projection of the imaging pinhole in the light-shielding layer onto the base substrate may be arranged within the first region, so as to prevent each imaging pinhole from being shielded by the metal film layer of the TFT array layer, thereby to perform the fingerprint identification in a better manner. In addition, in the display substrate according to at least one embodiment of the present disclosure, through the first protection layer between the light-shielding layer and the TFT array layer, it is able to effectively prevent plasmas from being accumulated on the light-shielding layer and prevent an electric arc from breaking down the light-shielding layer, thereby to improve a fingerprint identification effect.

During the implementation, the orthogonal projection of the first protection layer onto the base substrate may at least overlap a part of the first region, so as to prevent a portion of the light-shielding layer corresponding to the first region from being broken down by the electric arc to generate the light-leakage pinhole, thereby to prevent a fingerprint imaging effect from being adversely affected by stray light penetrating through the light-leakage pinhole.

Preferably, the forming the first protection layer at the side of the light-shielding layer distal to the base substrate may include: forming the first protection layer at the side of the light-shielding layer distal to the base substrate through a low temperature process, a film-forming temperature of the first protection layer is smaller than a threshold temperature, and the threshold temperature is greater than or equal to 230°C and smaller than or equal to 380°C.

Preferably, the first protection layer may be a low-temperature protection layer. The first protection layer may be formed through a low-temperature process after the deposition of the light-shielding layer, and then a film may be formed on the first protection layer at a high temperature and high power. Through the first protection layer, it is able to effectively prevent the plasmas from being accumulated on the light-shielding layer, thereby to prevent the occurrence of arc breakdown. A specific film-forming condition may depend on the imaging definition and the process requirements.

In at least one embodiment of the present disclosure, the forming the first protection layer at the side of the light-shielding layer distal to the base substrate through a low-temperature process may include forming the first protection layer at the side of the light-shielding layer distal to the base substrate through a low-temperature process using an inorganic material or an organic material.

The present disclosure further provides in at least one embodiment a display panel including the above-mentioned display substrate.

The present disclosure further provides in at least one embodiment a display device including the above-mentioned display panel.

The display device provided in at least one embodiment of the present disclosure may be any product or member having a display function, e.g., mobile phone, flat-panel computer, television, display, laptop computer, digital photo frame or navigator.

The above embodiments are preferable. The scope of protection is defined by the appended set of claims.

## Claims

1. A display substrate, comprising a base substrate (P1, P2), and a light-shielding layer (S1) and a Thin Film Transistor, TFT, array layer arranged sequentially in that order on the base substrate (P1, P2), wherein
a plurality of imaging pinholes (H1) is formed in the light-shielding layer (S1);
a first protection layer (P0) is arranged between the light-shielding layer (S1) and the TFT array layer;
the base substrate (P1, P2) is provided with a first region, an orthogonal projection of a metal film layer of the TFT array layer onto the base substrate (P1, P2) is located outside the first region, and at least a part of an orthogonal projection of the imaging pinhole (H1) onto the base substrate (P1, P2) is located within the first region, and the metal film layer of the TFT array layer comprises a first gate metal layer (G1), a second gate metal layer (G2) and a source/drain metal layer (Sd);
an orthogonal projection of the first protection layer (P0) onto the base substrate (P1, P2) at least covers a part of the first region;
the first region comprises a pinhole region (A0), and at least a part of the orthogonal projection of the imaging pinhole (H1) onto the base substrate (P1, P2) is located within the pinhole region (A0);
the orthogonal projection of the first protection layer (P0) onto the base substrate (P1, P2) at least covers the pinhole region (A0); and
the display substrate further comprises a buffer layer (Bf) arranged between the first protection layer (P0) and the TFT array layer,
wherein the first region comprises a fifth fifth sub-region (A5), the orthogonal projection of the imaging pinhole (HI) onto the base substrate (P1, P2) is not located within the fifth sub-region (A5);
**characterized in that**:
the TFT array layer comprises a first capacitor (C2), a threshold compensation transistor (T3), a first light-emission control transistor (T5), a first power source line (VDD) and a light-emission control signal line (EM); and
the fifth sub-region (A5) does not overlap an orthogonal projection of a first electrode plate (CC1a) of the first capacitor (C2) onto the base substrate (P1, P2), an orthogonal projection of the light-emission control signal line (EM) onto the base substrate (P1, P2), an orthogonal projection of the first power source line (VDD) onto the base substrate (P1, P2), and an orthogonal projection of a fourth conductive member (74) comprised in a semiconductor material layer pattern of the first light-emission control transistor (T5) onto the base substrate (P1, P2).

2. The display substrate according to claim 1, wherein the first region comprises a first sub-region (A1);
the TFT array layer comprises a resetting power source line (Vinit), a first resetting transistor (T6), a threshold compensation transistor (T3) and a driving transistor (T1);
the first sub-region (A1) does not overlap an orthogonal projection of a first conductive member (71) comprised in a semiconductor material layer pattern of the first resetting transistor (T6) onto the base substrate (P1, P2) and an orthogonal projection of a second conductive member (72) comprised in a semiconductor material layer pattern of the threshold compensation transistor (T3) onto the base substrate (P1, P2);
the first conductive member (71) is electrically connected to a first electrode (342a) of the first resetting transistor (T6), and the first electrode (342a) is electrically connected to the resetting power source line (Vinit);
the second conductive member (72) is electrically connected to a second electrode (341a) of the threshold compensation transistor (T3), and the second electrode (341a) is electrically connected to a gate electrode of the driving transistor (T1).

3. The display substrate according to claim 1, wherein the first region comprises a second sub-region (A2);
the TFT array layer comprises a gate line (Ga), a threshold compensation transistor (T3) and a driving transistor (T1);
the second sub-region (A2) does not overlap an orthogonal projection of the gate line (Ga) onto the base substrate (P1, P2), an orthogonal projection of a second electrode (341a) of the threshold compensation transistor (T3) onto the base substrate (P1, P2), an orthogonal projection of a second conductive member (72) comprised in a semiconductor material layer pattern of the threshold compensation transistor (T3) onto the base substrate (P1, P2), and an orthogonal projection of a first gate metal pattern (90) onto the base substrate (P1, P2);
the second conductive member (72) is electrically connected to the second electrode (341a) of the threshold compensation transistor (T3), and the second electrode (341a) is electrically connected to a gate electrode of the driving transistor (T1);
the first gate metal pattern (90) is a gate metal pattern arranged between the gate line (Ga) comprised in the first gate metal layer (G1) of the TFT array layer and the gate electrode of the threshold compensation transistor (T3).

4. The display substrate according to claim 1, wherein the first region comprises a third sub-region (A3);
the TFT array layer comprises a gate line (Ga), a threshold compensation transistor (T3) and a driving transistor (T1);
the third sub-region (A3) does not overlap an orthogonal protection of the gate line (Ga) onto the base substrate (P1, P2), an orthogonal projection of a third conductive member comprised in a semiconductor material layer pattern of the threshold compensation transistor (T3) onto the base substrate (P1, P2) and an orthogonal projection of a first gate metal pattern (90) onto the base substrate (P1, P2);
the semiconductor material layer pattern of the threshold compensation transistor (T3) comprises a first channel member (T3a1) and a second channel member (T3a2), and the third conductive member is arranged between the first channel member (T3a1) and the second channel member (T3a2);
the first gate metal pattern (90) is a gate metal pattern arranged between the gate line (Ga) comprised in the first gate metal layer (G1) of the TFT array layer and a gate electrode of the threshold compensation transistor (T3).

5. The display substrate according to claim 1, wherein the first region comprises a fourth sub-region (A4);
the TFT array layer comprises a gate line (Ga), a first capacitor (C2), a threshold compensation transistor (T3) and a first light-emission control transistor (T5);
the fourth sub-region (A4) does not overlap an orthogonal projection of the gate line (Ga) onto the base substrate (P1, P2), an orthogonal projection of a first electrode plate (CC1a) of the first capacitor (C2) onto the base substrate (P1, P2), an orthogonal projection of a second electrode (341a) of the threshold compensation transistor (T3) onto the base substrate (P1, P2), and an orthogonal projection of a fourth conductive member (74) comprised in a semiconductor material layer pattern of the first light-emission control transistor (T5) onto the base substrate (P1, P2);
a semiconductor material layer pattern of the threshold compensation transistor (T3) comprises a first channel member (T3a1) and a second channel member (T3a2), and the semiconductor material layer pattern of the first light-emission control transistor (T5) comprises a third channel member (T5a);
the fourth conductive member (74) is arranged between the second channel member (T3a2) and the third channel member (T5a).

6. The display substrate according to claim 1, wherein a semiconductor material layer pattern of the threshold compensation transistor (T3) comprises a first channel member (T3a1) and a second channel member (T3a2), and the semiconductor material layer pattern of the first light-emission control transistor (T5) comprises a third channel member (T5a);
the fourth conductive member (74) is arranged between the second channel member (T3a2) and the third channel member (T5a).

7. The display substrate according to claim 1, further comprising an anode layer (An) arranged at a side of the TFT array layer distal to the first protection layer (P0);
the TFT array layer comprises a first power source line (VDD) and a first light-emission control transistor (T5);
the pinhole region (A0) does not overlap an orthogonal projection of the first power source line (VDD) onto the base substrate (P1, P2) and an orthogonal projection of a third electrode (343a) of the first light-emission control transistor (T5) onto the base substrate (P1, P2);
the third electrode (343a) is electrically connected to the anode layer (An).

8. The display substrate according to claim 1, wherein
a thickness of the first protection layer (P0) is greater than or equal to 100nm and smaller than or equal to 400nm.

9. The display substrate according to claim 8, wherein the first protection layer (P0) is made of silicon oxide or silicon nitride.

10. The display substrate according to claim 1, further comprising a fingerprint identification layer (S0), the fingerprint identification layer (S0) is arranged at a side of the base substrate (P1, P2) distal to the light-shielding layer (S1), and comprises a fingerprint identification sensor;
the light-shielding layer (S1) is arranged at a light-entering side of the fingerprint identification sensor, and the imaging pinhole (H1) is arranged in such a manner as to allow light to pass through the imaging pinhole (H1) toward the fingerprint identification sensor.

11. The display substrate according to claim 1, further comprising a planarization layer (Pn) and an anode layer (An) arranged sequentially in that order at a side of the TFT array layer distal to the buffer layer (Bf);
an orthogonal projection of the imaging pinhole (H1) onto the base substrate (P1, P2) does not overlap an orthogonal projection of the anode layer (An) onto the base substrate (P1, P2).

12. A method for manufacturing the display substrate according to claim 1, comprising:
forming a light-shielding layer (S1) on a base substrate (P1, P2), the base substrate (P1, P2) being provided with a first region, a plurality of imaging pinholes (H1) being formed in the light-shielding layer (S1), at least a part of an orthogonal projection of the imaging pinhole (H1) onto the base substrate (P1, P2) being located within the first region;
forming a first protection layer (P0) at a side of the light-shielding layer (S1) distal to the base substrate (P1, P2);
forming a TFT array layer on the first protection layer (P0) in such a manner that an orthogonal projection of a metal film layer of the TFT array layer onto the base substrate (P1, P2) is located outside the first region, wherein the metal film layer of the TFT array layer comprises a first gate metal layer (G1), a second gate metal layer (G2) and a source/drain metal layer (Sd);
an orthogonal projection of the first protection layer (P0) onto the base substrate (P1, P2) at least covers a part of the first region;
the first region comprises a pinhole region (A0), at least a part of the orthogonal projection of the imaging pinhole (H1) onto the base substrate (P1, P2) is located within the pinhole region (A0), and the orthogonal projection of the first protection layer (P0) onto the base substrate (P1, P2) at least covers the pinhole region (A0),
wherein the first region comprises a fifth sub-region (A5);
the TFT array layer comprises a first capacitor (C2), a threshold compensation transistor (T3), a first light-emission control transistor (T5), a first power source line (VDD) and a light-emission control signal line (EM);
**characterized in that** the fifth sub-region (A5) does not overlap an orthogonal projection of a first electrode plate (CC1a) of the first capacitor (C2) onto the base substrate (P1, P2), an orthogonal projection of the light-emission control signal line (EM) onto the base substrate (P1, P2), an orthogonal projection of the first power source line (VDD) onto the base substrate (P1, P2), and an orthogonal projection of a fourth conductive member (74) comprised in a semiconductor material layer pattern of the first light-emission control transistor (T5) onto the base substrate (P1, P2).

13. The method according to claim 12, wherein the forming the first protection layer (P0) at the side of the light-shielding layer (S1) distal to the base substrate (P1, P2) comprises:
forming the first protection layer (P0) at the side of the light-shielding layer (S1) distal to the base substrate (P1, P2) through a low temperature process, a film-forming temperature of the first protection layer (P0) is smaller than a threshold temperature;
the threshold temperature is greater than or equal to 230°C and smaller than or equal to 380°C.

14. A display panel, **characterized by** comprising the display substrate according to any one of claims 1 to 11.

15. A display device, **characterized by** comprising the display panel according to claim 14.

## Patentansprüche

1. Anzeigesubstrat, umfassend ein Basissubstrat (P1, P2) und eine Lichtabschirmungsschicht (S1) und eine Dünnfilmtransistor-Array-Schicht (TFT-Array-Schicht), die nacheinander in dieser Reihenfolge auf dem Basissubstrat (P1, P2) angeordnet sind, wobei
mehrere Bildgebungs-Lochblenden (H1) in der Lichtabschirmungsschicht (S1) gebildet sind;
eine erste Schutzschicht (P0) zwischen der Lichtabschirmungsschicht (S1) und der TFT-Array-Schicht angeordnet ist;
das Basissubstrat (P1, P2) mit einer ersten Region versehen ist, wobei sich eine orthogonale Projektion einer Metallfilmschicht der TFT-Array-Schicht auf das Basissubstrat (P1, P2) außerhalb der ersten Region befindet, und wobei sich mindestens ein Teil einer orthogonalen Projektion der Bildgebungs-Lochblende (H1) auf das Basissubstrat (P1, P2) innerhalb der ersten Region befindet und die Metallfilmschicht der TFT-Array-Schicht eine erste Gate-Metallschicht (G1), eine zweite Gate-Metallschicht (G2) und eine Source/Drain-Metallschicht (Sd) umfasst;
eine orthogonale Projektion der ersten Schutzschicht (P0) auf das Basissubstrat (P1, P2) mindestens einen Teil der ersten Region bedeckt;
die erste Region eine Lochblendenregion (A0) umfasst und sich mindestens ein Teil der orthogonalen Projektion der Bildgebungs-Lochblende (H1) auf das Basissubstrat (P1, P2) innerhalb der Lochblendenregion (A0) befindet;
die orthogonale Projektion der ersten Schutzschicht (P0) auf das Basissubstrat (P1, P2) mindestens die Lochblendenregion (A0) bedeckt; und
das Anzeigesubstrat des Weiteren eine Pufferschicht (Bf) umfasst, die zwischen der ersten Schutzschicht (P0) und der TFT-Array-Schicht angeordnet ist,
wobei die erste Region eine fünfte Teilregion (A5) umfasst, sich die orthogonale Projektion der Bildgebungs-Lochblende (H1) auf das Basissubstrat (P1, P2) nicht innerhalb der fünften Teilregion (A5) befindet;
**dadurch gekennzeichnet, dass**:
die TFT-Array-Schicht einen ersten Kondensator (C2), einen Schwellenkompensationstransistor (T3), einen ersten Lichtemissionssteuertransistor (T5), eine erste Stromquellenleitung (VDD) und eine Lichtemissionssteuersignalleitung (EM) umfasst; und
die fünfte Teilregion (A5) weder eine orthogonale Projektion einer ersten Elektrodenplatte (CC1a) des ersten Kondensators (C2) auf das Basissubstrat (P1, P2), noch eine orthogonale Projektion der Lichtemissionssteuersignalleitung (EM) auf das Basissubstrat (P1, P2), noch eine orthogonale Projektion der ersten Stromquellenleitung (VDD) auf das Basissubstrat (P1, P2), noch eine orthogonale Projektion eines vierten leitfähigen Elements (74), das in einer Halbleitermaterialschichtstruktur des ersten Lichtemissionssteuertransistors (T5) enthalten ist, auf das Basissubstrat (P1, P2) überlappt.

2. Anzeigesubstrat nach Anspruch 1, wobei die erste Region eine erste Teilregion (A1) umfasst;
wobei die TFT-Array-Schicht eine Rücksetz-Stromquellenleitung (Vinit), einen ersten Rücksetztransistor (T6), einen Schwellenkompensationstransistor (T3) und einen Ansteuertransistor (T1) umfasst;
die erste Teilregion (A1) weder eine orthogonale Projektion eines ersten leitfähigen Elements (71), das in einer Halbleitermaterialschichtstruktur des ersten Rücksetztransistors (T6) enthalten ist, auf das Basissubstrat (P1, P2) noch eine orthogonale Projektion eines zweiten leitfähigen Elements (72), das in einer Halbleitermaterialschichtstruktur des Schwellenkompensationstransistors (T3) enthalten ist, auf das Basissubstrat (P1, P2) überlappt;
das erste leitfähige Element (71) elektrisch mit einer ersten Elektrode (342a) des ersten Rücksetz-Transistors (T6) verbunden ist, und die erste Elektrode (342a) elektrisch mit der Rücksetz-Stromquellenleitung (Vinit) verbunden ist;
das zweite leitfähige Element (72) elektrisch mit einer zweiten Elektrode (341a) des Schwellenkompensationstransistors (T3) verbunden ist, und die zweite Elektrode (341a) elektrisch mit einer Gate-Elektrode des Ansteuertransistors (T1) verbunden ist.

3. Anzeigesubstrat nach Anspruch 1, wobei die erste Region eine zweite Teilregion (A2) umfasst;
die TFT-Array-Schicht eine Gate-Leitung (Ga), einen Schwellenkompensationstransistor (T3) und einen Ansteuertransistor (T1) umfasst;
die zweite Teilregion (A2) weder eine orthogonale Projektion der Gate-Leitung (Ga) auf das Basissubstrat (P1, P2), noch eine orthogonale Projektion einer zweiten Elektrode (341a) des Schwellenkompensationstransistors (T3) auf das Basissubstrat (P1, P2), noch eine orthogonale Projektion eines zweiten leitfähigen Elements (72), das in einer Halbleitermaterialschichtstruktur des Schwellenkompensationstransistors (T3) enthalten ist, auf das Basissubstrat (P1, P2), noch eine orthogonale Projektion einer ersten Gate-Metallstruktur (90) auf das Basissubstrat (P1, P2) überlappt;
das zweite leitfähige Element (72) elektrisch mit der zweiten Elektrode (341a) des Schwellenkompensationstransistors (T3) verbunden ist, und die zweite Elektrode (341a) elektrisch mit einer Gate-Elektrode des Ansteuertransistors (T1) verbunden ist;
die erste Gate-Metallstruktur (90) eine Gate-Metallstruktur ist, die zwischen der Gate-Leitung (Ga), die in der ersten Gate-Metallschicht (G1) der TFT-Array-Schicht enthalten ist, und der Gate-Elektrode des Schwellenkompensationstransistors (T3) angeordnet ist.

4. Anzeigesubstrat nach Anspruch 1, wobei die erste Region eine dritte Teilregion (A3) umfasst;
die TFT-Array-Schicht eine Gate-Leitung (Ga), einen Schwellenkompensationstransistor (T3) und einen Ansteuertransistor (T1) umfasst;
die dritte Teilregion (A3) weder einen orthogonalen Schutz der Gate-Leitung (Ga) auf das Basissubstrat (P1, P2), noch eine orthogonale Projektion eines dritten leitfähigen Elements, das in einer Halbleitermaterialschichtstruktur des Schwellenkompensationstransistors (T3) enthalten ist, auf das Basissubstrat (P1, P2), noch eine orthogonale Projektion einer ersten Gate-Metallstruktur (90) auf das Basissubstrat (P1, P2) überlappt;
die Halbleitermaterialschichtstruktur des Schwellenkompensationstransistors (T3) ein erstes Kanalelement (T3a1) und ein zweites Kanalelement (T3a2) umfasst, und das dritte leitfähige Element zwischen dem ersten Kanalelement (T3a1) und dem zweiten Kanalelement (T3a2) angeordnet ist;
die erste Gate-Metallstruktur (90) eine Gate-Metallstruktur ist, die zwischen der Gate-Leitung (Ga), die in der ersten Gate-Metallschicht (G1) der TFT-Array-Schicht enthalten ist, und einer Gate-Elektrode des Schwellenkompensationstransistors (T3) angeordnet ist.

5. Anzeigesubstrat nach Anspruch 1, wobei die erste Region eine vierte Teilregion (A4) umfasst;
die TFT-Array-Schicht eine Gate-Leitung (Ga), einen ersten Kondensator (C2), einen Schwellenkompensationstransistor (T3) und einen ersten Lichtemissionssteuertransistor (T5) umfasst;
die vierte Teilregion (A4) weder eine orthogonale Projektion der Gate-Leitung (Ga) auf das Basissubstrat (P1, P2), noch eine orthogonale Projektion einer ersten Elektrodenplatte (CC1a) des ersten Kondensators (C2) auf das Basissubstrat (P1, P2), noch eine orthogonale Projektion einer zweiten Elektrode (341a) des Schwellenkompensationstransistors (T3) auf das Basissubstrat (P1, P2), noch eine orthogonale Projektion eines vierten leitfähigen Elements (74), das in einer Halbleitermaterialschichtstruktur des ersten Lichtemissionssteuertransistors (T5) enthalten ist, auf das Basissubstrat (P1, P2) überlappt.
eine Halbleitermaterialschichtstruktur des Schwellenkompensationstransistors (T3) ein erstes Kanalelement (T3a1) und ein zweites Kanalelement (T3a2) umfasst, und die Halbleitermaterialschichtstruktur des ersten Lichtemissionssteuertransistors (T5) ein drittes Kanalelement (T5a) umfasst;
das vierte leitfähige Element (74) zwischen dem zweiten Kanalelement (T3a2) und dem dritten Kanalelement (T5a) angeordnet ist.

6. Anzeigesubstrat nach Anspruch 1, wobei eine Halbleitermaterialschichtstruktur des Schwellenkompensationstransistors (T3) ein erstes Kanalelement (T3a1) und ein zweites Kanalelement (T3a2) umfasst und die Halbleitermaterialschichtstruktur des ersten Lichtemissionssteuertransistors (T5) ein drittes Kanalelement (T5a) umfasst;
das vierte leitfähige Element (74) zwischen dem zweiten Kanalelement (T3a2) und dem dritten Kanalelement (T5a) angeordnet ist.

7. Anzeigesubstrat nach Anspruch 1, des Weiteren umfassend eine Anodenschicht (An), die an einer Seite der TFT-Array-Schicht von der ersten Schutzschicht (P0) entfernt angeordnet ist;
die TFT-Array-Schicht eine erste Stromquellenleitung (VDD) und einen ersten Lichtemissionssteuertransistor (T5) umfasst;
die Lochblendenregion (A0) weder eine orthogonale Projektion der ersten Stromquellenleitung (VDD) auf das Basissubstrat (P1, P2), noch eine orthogonale Projektion einer dritten Elektrode (343a) des ersten Lichtemissionssteuertransistors (T5) auf das Basissubstrat (P1, P2) überlappt;
die dritte Elektrode (343a) elektrisch mit der Anodenschicht (An) verbunden ist.

8. Anzeigesubstrat nach Anspruch 1, wobei:
eine Dicke der ersten Schutzschicht (P0) größer als oder gleich 100 nm und kleiner als oder gleich 400 nm ist.

9. Anzeigesubstrat nach Anspruch 8, wobei die erste Schutzschicht (P0) aus Siliziumoxid oder Siliziumnitrid hergestellt ist.

10. Anzeigesubstrat nach Anspruch 1, des Weiteren umfassend eine Fingerabdruckidentifikationsschicht (S0) umfasst, wobei die Fingerabdruckidentifikationsschicht (S0) an einer Seite des Basissubstrats (P1, P2) angeordnet ist, die sich von der Lichtabschirmungsschicht (S1) entfernt befindet, und einen Fingerabdruckidentifikationssensor umfasst;
die Lichtabschirmungsschicht (S1) an einer Lichteintrittsseite des Fingerabdruckidentifikationssensors angeordnet ist, und die Bildgebungs-Lochblende (H1) in einer solchen Weise angeordnet ist, dass Licht durch die Bildgebungs-Lochblende (H1) hindurch in Richtung des Fingerabdruckidentifikationssensors passieren kann.

11. Anzeigesubstrat nach Anspruch 1, des Weiteren umfassend eine Planarisierungsschicht (Pn) und eine Anodenschicht (An), die nacheinander in dieser Reihenfolge an einer Seite der TFT-Array-Schicht von der Pufferschicht (Bf) entfernt angeordnet sind;
eine orthogonale Projektion der Bildgebungs-Lochblende (H1) auf das Basissubstrat (P1, P2) keine orthogonale Projektion der Anodenschicht (An) auf das Basissubstrat (P1, P2) überlappt.

12. Verfahren zur Herstellung des Anzeigesubstrats nach Anspruch 1, umfassend:
Bilden einer Lichtabschirmungsschicht (S1) auf einem Basissubstrat (P1, P2), wobei das Basissubstrat (P1, P2) mit einer ersten Region versehen ist, wobei mehrere Bildgebungs-Lochblenden (H1) in der Lichtabschirmungsschicht (S1) gebildet sind, wobei sich mindestens ein Teil einer orthogonalen Projektion der Bildgebungs-Lochblende (H1) auf das Basissubstrat (P1, P2) innerhalb der ersten Region befindet;
Bilden einer ersten Schutzschicht (P0) an einer Seite der Lichtabschirmungsschicht (S1), die sich von dem Basissubstrat (P1, P2) entfernt befindet;
Bilden einer TFT-Array-Schicht auf der ersten Schutzschicht (P0) in einer solchen Weise, dass sich eine orthogonale Projektion einer Metallfilmschicht der TFT-Array-Schicht auf das Basissubstrat (P1, P2) außerhalb der ersten Region befindet, wobei die Metallfilmschicht der TFT-Array-Schicht eine erste Gate-Metallschicht (G1), eine zweite Gate-Metallschicht (G2) und eine Source/Drain-Metallschicht (Sd) umfasst;
eine orthogonale Projektion der ersten Schutzschicht (P0) auf das Basissubstrat (P1, P2) mindestens einen Teil der ersten Region bedeckt;
die erste Region eine Lochblendenregion (A0) umfasst, wobei sich mindestens ein Teil der orthogonalen Projektion der Bildgebungs-Lochblende (H1) auf das Basissubstrat (P1, P2) innerhalb der Lochblendenregion (A0) befindet, und die orthogonale Projektion der ersten Schutzschicht (P0) auf das Basissubstrat (P1, P2) mindestens die Lochblendenregion (A0) bedeckt,
wobei die erste Region eine fünfte Teilregion (A5) umfasst;
die TFT-Array-Schicht einen ersten Kondensator (C2), einen Schwellenkompensationstransistor (T3), einen ersten Lichtemissionssteuertransistor (T5), eine erste Stromquellenleitung (VDD) und eine Lichtemissionssteuersignalleitung (EM) umfasst;
**dadurch gekennzeichnet, dass** die fünfte Teilregion (A5) weder eine orthogonale Projektion einer ersten Elektrodenplatte (CCI) des ersten Kondensators (C2) auf das Basissubstrat (P1, P2), noch eine orthogonale Projektion der Lichtemissionssteuersignalleitung (EM) auf das Basissubstrat (P1, P2), noch eine orthogonale Projektion der ersten Stromquellenleitung (VDD) auf das Basissubstrat (P1, P2), noch eine orthogonale Projektion eines vierten leitfähigen Elements (74), das in einer Halbleitermaterialschichtstruktur des ersten Lichtemissionssteuertransistors (T5) enthalten ist, auf das Basissubstrat (P1, P2) überlappt.

13. Verfahren nach Anspruch 12, wobei das Bilden der ersten Schutzschicht (P0) an der Seite der Lichtabschirmungsschicht (S1), die sich von dem Basissubstrat (P1, P2) entfernt befindet, umfasst:
Bilden der ersten Schutzschicht (P0) an der Seite der Lichtabschirmungsschicht (S1), die sich von dem Basissubstrat (P1, P2) entfernt befindet, durch einen Niedrigtemperaturprozess, wobei eine Filmbildungstemperatur der ersten Schutzschicht (P0) niedriger als eine Schwellentemperatur ist;
wobei die Schwellentemperatur größer als oder gleich 230 °C und kleiner als oder gleich 380 °C ist.

14. Anzeigetafel, **dadurch gekennzeichnet, dass** sie das Anzeigesubstrat nach einem der Ansprüche 1 bis 11 umfasst.

15. Anzeigevorrichtung, **dadurch gekennzeichnet, dass** sie die Anzeigetafel nach Anspruch 14 umfasst.

## Revendications

1. Substrat d'affichage comprenant un substrat de base (P1, P2), une couche de blindage contre la lumière (S1) et une couche de réseau de transistors à couche mince, TFT, disposées séquentiellement dans cet ordre sur le substrat de base (P1, P2), dans lequel :
une pluralité de sténopés d'imagerie (H1) est formée dans la couche de blindage contre la lumière (S1) ;
une première couche de protection (P0) est disposée entre la couche de blindage contre la lumière (S1) et la couche de réseau de TFT ;
le substrat de base (P1, P2) est pourvu d'une première région, une projection orthogonale d'une couche de film métallique de la couche de réseau de TFT sur le substrat de base (P1, P2) est située à l'extérieur de la première région, et au moins une partie d'une projection orthogonale du sténopé d'imagerie (H1) sur le substrat de base (P1, P2) est située à l'intérieur de la première région, et la couche de film métallique de la couche de réseau de TFT comprend une première couche métallique de grille (G1), une deuxième couche métallique de grille (G2) et une couche métallique de source/drain (Sd) ;
une projection orthogonale de la première couche de protection (P0) sur le substrat de base (P1, P2) recouvre au moins une partie de la première région ;
la première région comprend une région de sténopé (A0), et au moins une partie de la projection orthogonale du sténopé d'imagerie (H1) sur le substrat de base (P1, P2) est située à l'intérieur de la région de sténopé (A0) ;
la projection orthogonale de la première couche de protection (P0) sur le substrat de base (P1, P2) recouvre au moins la région de sténopé (A0) ; et
le substrat d'affichage comprend en outre une couche tampon (Bf) disposée entre la première couche de protection (P0) et la couche de réseau de TFT,
dans lequel la première région comprend une cinquième sous-région (A5), la projection orthogonale du sténopé d'imagerie (H1) sur le substrat de base (P1, P2) n'est pas située à l'intérieur de la cinquième sous-région (A5) ;
**caractérisé en ce que** :
la couche de réseau de TFT comprend un premier condensateur (C2), un transistor de compensation de seuil (T3), un premier transistor de commande d'émission de lumière (T5), une première ligne de source d'alimentation (VDD), et une ligne de signal de commande d'émission de lumière (EM) ; et
la cinquième sous-région (A5) ne chevauche pas une projection orthogonale d'une première plaque d'électrode (CC1a) du premier condensateur (C2) sur le substrat de base (P1, P2), une projection orthogonale de la ligne de signal de commande d'émission de lumière (EM) sur le substrat de base (P1, P2), une projection orthogonale de la première ligne de source d'alimentation (VDD) sur le substrat de base (P1, P2) et une projection orthogonale d'un quatrième élément conducteur (74) compris dans un motif de couche de matériau semi-conducteur du premier transistor de commande d'émission de lumière (T5) sur le substrat de base (P1, P2).

2. Substrat d'affichage selon la revendication 1, dans lequel la première région comprend une première sous-région (A1) ;
la couche de réseau de TFT comprend une ligne de source d'alimentation de réinitialisation (Vinit), un premier transistor de réinitialisation (T6), un transistor de compensation de seuil (T3) et un transistor d'attaque (T1) ;
la première sous-région (A1) ne chevauche pas une projection orthogonale d'un premier élément conducteur (71) compris dans un motif de couche de matériau semi-conducteur du premier transistor de réinitialisation (T6) sur le substrat de base (P1, P2) et une projection orthogonale d'un deuxième élément conducteur (72) compris dans un motif de couche de matériau semi-conducteur du transistor de compensation de seuil (T3) sur le substrat de base (P1, P2) ;
le premier élément conducteur (71) est connecté électriquement à une première électrode (342a) du premier transistor de réinitialisation (T6) et la première électrode (342a) est connectée électriquement à la ligne de source d'alimentation de réinitialisation (Vinit) ;
le deuxième élément conducteur (72) est connecté électriquement à une deuxième électrode (341a) du transistor de compensation de seuil (T3) et la deuxième électrode (341a) est connectée électriquement à une électrode de grille du transistor d'attaque (T1).

3. Substrat d'affichage selon la revendication 1, dans lequel la première région comprend une deuxième sous-région (A2) ;
la couche de réseau de TFT comprend une ligne de grille (Ga), un transistor de compensation de seuil (T3) et un transistor d'attaque (T1) ;
la deuxième sous-région (A2) ne chevauche pas une projection orthogonale de la ligne de grille (Ga) sur le substrat de base (P1, P2), une projection orthogonale d'une deuxième électrode (341a) du transistor de compensation de seuil (T3) sur le substrat de base (P1, P2), une projection orthogonale d'un deuxième élément conducteur (72) compris dans un motif de couche de matériau semi-conducteur du transistor de compensation de seuil (T3) sur le substrat de base (P1, P2) et une projection orthogonale d'un premier motif métallique de grille (90) sur le substrat de base (P1, P2) ;
le deuxième élément conducteur (72) est connecté électriquement à la deuxième électrode (341a) du transistor de compensation de seuil (T3) et la deuxième électrode (341a) est connectée électriquement à une électrode de grille du transistor d'attaque (T1) ;
le premier motif métallique de grille (90) est un motif métallique de grille disposé entre la ligne de grille (Ga) comprise dans la première couche métallique de grille (G1) de la couche de réseau de TFT et l'électrode de grille du transistor de compensation de seuil (T3).

4. Substrat d'affichage selon la revendication 1, dans lequel la première région comprend une troisième sous-région (A3) ;
la couche de réseau de TFT comprend une ligne de grille (Ga), un transistor de compensation de seuil (T3) et un transistor d'attaque (T1) ;
la troisième sous-région (A3) ne chevauche pas une protection orthogonale de la ligne de grille (Ga) sur le substrat de base (P1, P2), une projection orthogonale d'un troisième élément conducteur compris dans un motif de couche de matériau semi-conducteur du transistor de compensation de seuil (T3) sur le substrat de base (P1, P2) et une projection orthogonale d'un premier motif métallique de grille (90) sur le substrat de base (P1, P2) ;
le motif de couche de matériau semi-conducteur du transistor de compensation de seuil (T3) comprend un premier élément de canal (T3a1) et un deuxième élément de canal (T3a2), et le troisième élément conducteur est disposé entre le premier élément de canal (T3a1) et le deuxième élément de canal (T3a2) ;
le premier motif métallique de grille (90) est un motif métallique de grille disposé entre la ligne de grille (Ga) comprise dans la première couche métallique de grille (G1) de la couche de réseau de TFT et une électrode de grille du transistor de compensation de seuil (T3).

5. Substrat d'affichage selon la revendication 1, dans lequel la première région comprend une quatrième sous-région (A4) ;
la couche de réseau de TFT comprend une ligne de grille (Ga), un premier condensateur (C2), un transistor de compensation de seuil (T3) et un premier transistor de commande d'émission de lumière (T5) ;
la quatrième sous-région (A4) ne chevauche pas une projection orthogonale de la ligne de grille (Ga) sur le substrat de base (P1, P2), une projection orthogonale d'une première plaque d'électrode (CC1a) du premier condensateur (C2) sur le substrat de base (P1, P2), une projection orthogonale d'une deuxième électrode (341a) du transistor de compensation de seuil (T3) sur le substrat de base (P1, P2) et une projection orthogonale d'un quatrième élément conducteur (74) compris dans un motif de couche de matériau semi-conducteur du premier transistor de commande d'émission de lumière (T5) sur le substrat de base (P1, P2) ;
un motif de couche de matériau semi-conducteur du transistor de compensation de seuil (T3) comprend un premier élément de canal (T3a1) et un deuxième élément de canal (T3a2), et le motif de couche de matériau semi-conducteur du premier transistor de commande d'émission de lumière (T5) comprend un troisième élément de canal (T5a) ;
le quatrième élément conducteur (74) est disposé entre le deuxième élément de canal (T3a2) et le troisième élément de canal (T5a).

6. Substrat d'affichage selon la revendication 1, dans lequel un motif de couche de matériau semi-conducteur du transistor de compensation de seuil (T3) comprend un premier élément de canal (T3a1) et un deuxième élément de canal (T3a2), et le motif de couche de matériau semi-conducteur du premier transistor de commande d'émission de lumière (T5) comprend un troisième élément de canal (T5a) ;
le quatrième élément conducteur (74) est disposé entre le deuxième élément de canal (T3a2) et le troisième élément de canal (T5a).

7. Substrat d'affichage selon la revendication 1, comprenant en outre une couche d'anode (An) disposée sur un côté de la couche de réseau de TFT distal par rapport à la première couche de protection (P0) ;
la couche de réseau de TFT comprend une première ligne de source d'alimentation (VDD) et un premier transistor de commande d'émission de lumière (T5) ;
la région de sténopé (A0) ne chevauche pas une projection orthogonale de la première ligne de source d'alimentation (VDD) sur le substrat de base (P1, P2) et une projection orthogonale d'une troisième électrode (343a) du premier transistor de commande d'émission de lumière (T5) sur le substrat de base (P1, P2) ;
la troisième électrode (343a) est connectée électriquement à la couche d'anode (An).

8. Substrat d'affichage selon la revendication 1, dans lequel
Une épaisseur de la première couche de protection (P0) est supérieure ou égale à 100 nm et inférieure ou égale à 400 nm.

9. Substrat d'affichage selon la revendication 8, dans lequel la première couche de protection (P0) est constituée d'oxyde de silicium ou de nitrure de silicium.

10. Substrat d'affichage selon la revendication 1, comprenant en outre une couche d'identification d'empreintes digitales (S0), la couche d'identification d'empreintes digitales (S0) étant disposée sur un côté du substrat de base (P1, P2) distal par rapport à la couche de blindage contre la lumière (S1), et comprenant un capteur d'identification d'empreintes digitales ;
la couche de blindage contre la lumière (S1) est disposée sur un côté d'entrée de lumière du capteur d'identification d'empreintes digitales, et le sténopé d'imagerie (H1) est disposé de manière à permettre à la lumière de passer à travers le sténopé d'imagerie (H1) vers le capteur d'identification d'empreintes digitales.

11. Substrat d'affichage selon la revendication 1, comprenant en outre une couche de planarisation (Pn) et une couche d'anode (An) disposées séquentiellement dans cet ordre sur un côté de la couche de réseau de TFT distal par rapport à la couche tampon (Bf) ;
une projection orthogonale du sténopé d'imagerie (H1) sur le substrat de base (P1, P2) ne chevauche pas une projection orthogonale de la couche d'anode (An) sur le substrat de base (P1, P2).

12. Procédé de fabrication du substrat d'affichage selon la revendication 1, consistant à :
former une couche de blindage contre la lumière (S1) sur un substrat de base (P1, P2), le substrat de base (P1, P2) étant pourvu d'une première région, une pluralité de sténopés d'imagerie (H1) étant formés dans la couche de blindage contre la lumière (S1), au moins une partie d'une projection orthogonale du sténopé d'imagerie (H1) sur le substrat de base (P1, P2) étant située à l'intérieur de la première région ;
former une première couche de protection (P0) sur un côté de la couche de blindage contre la lumière (S1) distal par rapport au substrat de base (P1, P2) ;
former une couche de réseau de TFT sur la première couche de protection (P0) de telle sorte qu'une projection orthogonale d'une couche de film métallique de la couche de réseau de TFT sur le substrat de base (P1, P2) soit située à l'extérieur de la première région, dans lequel la couche de film métallique de la couche de réseau de TFT comprend une première couche métallique de grille (G1), une deuxième couche métallique de grille (G2) et une couche métallique de source/drain (Sd) ;
une projection orthogonale de la première couche de protection (P0) sur le substrat de base (P1, P2) recouvre au moins une partie de la première région ;
la première région comprend une région de sténopé (A0), au moins une partie de la projection orthogonale du sténopé d'imagerie (H1) sur le substrat de base (P1, P2) est située à l'intérieur de la région de sténopé (A0), et la projection orthogonale de la première couche de protection (P0) sur le substrat de base (P1, P2) recouvre au moins la région de sténopé (A0),
dans lequel la première région comprend une cinquième sous-région (A5) ;
la couche de réseau de TFT comprend un premier condensateur (C2), un transistor de compensation de seuil (T3), un premier transistor de commande d'émission de lumière (T5), une première ligne de source d'alimentation (VDD) et une ligne de signal de commande d'émission de lumière (EM) ;
**caractérisé en ce que** la cinquième sous-région (A5) ne chevauche pas une projection orthogonale d'une première plaque d'électrode (CC1a) du premier condensateur (C2) sur le substrat de base (P1, P2), une projection orthogonale de la ligne de signal de commande d'émission de lumière (EM) sur le substrat de base (P1, P2), une projection orthogonale de la première ligne de source d'alimentation (VDD) sur le substrat de base (P1, P2) et une projection orthogonale d'un quatrième élément conducteur (74) compris dans un motif de couche de matériau semi-conducteur du premier transistor de commande d'émission de lumière (T5) sur le substrat de base (P1, P2).

13. Procédé selon la revendication 12, dans lequel former la première couche de protection (P0) sur le côté de la couche de blindage contre la lumière (S1) distal par rapport au substrat de base (P1, P2) consiste à :
former la première couche de protection (P0) sur le côté de la couche de blindage contre la lumière (S1) distal par rapport au substrat de base (P1, P2) par un procédé à basse température, la température de formation de film de la première couche de protection (P0) étant inférieure à une température seuil ;
la température seuil étant supérieure ou égale à 230 °C et inférieure ou égale à 380 °C.

14. Écran d'affichage, **caractérisé en ce qu'**il comprend le substrat d'affichage selon l'une quelconque des revendications 1 à 11.

15. Dispositif d'affichage, **caractérisé en ce qu'**il comprend l'écran d'affichage selon la revendication 14.
